# FASCICULE DE BREVET EUROPEEN

(11) **EP 1 774 589 B1**
(45) Date de publication et mention de la délivrance du brevet: **28.07.2010**
(21) Numéro de dépôt: 05782182.9
(22) Date de dépôt: 29.06.2005
(51) Int. Cl.: H01L 21/98, H01L 25/065, H01L 21/18

(54) **ASSEMBLAGE PAR ADHESION MOLECULAIRE DE DEUX SUBSTRATS, L'UN AU MOINS SUPPORTANT UN FILM CONDUCTEUR ELECTRIQUE**
ZUSAMMENFÜGEN EINES SUBSTRATES MIT EINEM ELEKTRISCH LEITENDEN FILM MIT EINEM ZWEITEN SUBSTRAT DURCH MOLEKULARE ADHÄSION
ASSEMBLING TWO SUBSTRATES BY MOLECULAR ADHESION, ONE OF THE TWO SUPPORTING AN ELECTRICALLY CONDUCTIVE FILM

(30) Priorité: 30.06.2004 FR 0451376
(43) Date de publication de la demande: 18.04.2007
(73) Titulaire: Commissariat à l'Énergie Atomique et aux Énergies Alternatives, 75015 Paris (FR)
(72) Inventeur: MORICEAU, Hubert, F-38120 SAINT EGREVE (FR); FEUILLET, Guy, F-38410 SAINT MARTIN D'URIAGE (FR); POCAS, Stéphane, F-38000 GRENOBLE (FR)
(74) Mandataire: Poulin, Gérard
(86) Numéro de dépôt international: PCT/FR2005/050521
(87) Numéro de publication internationale: WO 2006/008410

(56) Documents cités:
- FR-A- 2 783 969
- US-B1- 6 274 892
- SHIYANG ZHU ET AL: "Buried cobalt silicide layer under thin silicon film fabricated by wafer bonding and hydrogen-induced delamination techniques" JOURNAL OF THE ELECTROCHEMICAL SOCIETY, ELECTROCHEMICAL SOCIETY. MANCHESTER, NEW HAMPSHIRE, US, vol. 146, no. 7, juillet 1999 (1999-07), pages 2712-2716, XP002291929 ISSN: 0013-4651
- ISMAIL M S ET AL: "PLATINUM SILICIDE FUSION BONDING" ELECTRONICS LETTERS, IEE STEVENAGE, GB, vol. 27, no. 13, 20 juin 1991 (1991-06-20), pages 1153-1155, XP000238688 ISSN: 0013-5194
- PLOSZL A ET AL: "Wafer direct bonding: tailoring adhesion between brittle materials" MATERIALS SCIENCE AND ENGINEERING R: REPORTS, ELSEVIER SEQUOIA S.A., LAUSANNE, CH, vol. 25, no. 1-2, 10 mars 1999 (1999-03-10), pages 1-88, XP004167445 ISSN: 0927-796X
- SHIGETOU A ET AL: "Room temperature bonding of ultra-fine pitch and low-profiled Cu electrodes for bump-less interconnect" 2003 PROCEEDINGS 53RD. ELECTRONIC COMPONENTS AND TECHNOLOGY CONFERENCE. (ECTC). NEW ORLEANS, LA, MAY 27 - 30, 2003, PROCEEDINGS OF THE ELECTRONIC COMPONENTS AND TECHNOLOGY CONFERENCE, NEW YORK, NY : IEEE, US, vol. CONF. 53, 27 mai 2003 (2003-05-27), pages 848-852, XP010648104 ISBN: 0-7803-7991-5 cité dans la demande
- LJUNGBERG K ET AL: "BURIED COBALT SILICIDE LAYERS IN SILICON CREATED BY WAFER BONDING" JOURNAL OF THE ELECTROCHEMICAL SOCIETY, ELECTROCHEMICAL SOCIETY. MANCHESTER, NEW HAMPSHIRE, US, vol. 141, no. 10, 1 octobre 1994 (1994-10-01), pages 2829-2833, XP000493983 ISSN: 0013-4651

## Description

### DOMAINE TECHNIQUE

L'invention concerne un procédé d'assemblage par adhésion moléculaire de deux substrats, l'un au moins desdits substrats supportant un film conducteur électrique.

### ÉTAT DE LA TECHNIQUE ANTÉRIEURE

Dans le domaine de la microélectronique, il est souvent nécessaire d'assembler deux substrats selon des faces principales de ces substrats. Il peut s'agir par exemple de reporter une couche mince délimitée dans un substrat semi-conducteur de qualité électronique sur un autre substrat servant de support. Une technique appréciée pour réaliser un tel assemblage est l'adhésion moléculaire qui évite l'utilisation d'une substance adhésive. Cette technique est particulièrement efficace pour fixer deux substrats semi-conducteurs de même nature, par exemple deux substrats de silicium. Dans ce cas, on améliore encore cette efficacité si les faces à mettre en contact sont recouvertes d'un oxyde. Cependant, les faces à mettre en contact peuvent présenter des zones métalliques.

De nombreux documents de l'art antérieur présentent des procédés permettant d'assembler des substrats à l'aide de films métalliques.

Par exemple, les auteurs B. Aspar et al. expliquent dans le document **[1]** qu'il est possible de réaliser l'assemblage de deux substrats de silicium à l'aide de films de palladium à température ambiante.

Dans le document **[2],** les auteurs Thüngstrom et al. présentent un procédé de siliciuration du cobalt après collage de deux films métalliques de Co déposés sur deux substrats de silicium dopé N et/ou P.

Enfin, les auteurs Shigetou et al. divulguent dans le document **[3]** comment réaliser des collages métalliques de cuivre localisés à l'aide d'une technique permettant d'obtenir des électrodes de profils bien contrôlés.

Les auteurs de ces différents documents s'intéressent tous à l'obtention d'une conduction électrique au niveau d'un collage de deux substrats. Cependant, ils ne présentent pas de procédés permettant d'obtenir un bon collage sur toute la surface des substrats à assembler. On entend par bon collage un collage ne présentant pas de défaut tels que des bulles ou des particules emprisonnées entre les deux substrats, et ayant une forte énergie de collage dès les basses températures.

Par ailleurs, la conduction obtenue dans ces documents au niveau de l'interface de collage est à une échelle « macroscopique » et ne peut être contrôlée en toute zone de la surface. Elle apparaît comme une valeur moyennée sur la surface de collage considérée. Or cette dispersion des résultats de conduction verticale à l'interface de deux substrats peut être problématique, en particulier si on veut obtenir une structure ayant des petites surfaces de conduction verticales.

Les structures de l'art antérieur obtenues par l'assemblage de deux substrats à l'aide d'un film métallique par adhérence moléculaire présentent un collage qui n'est pas de bonne qualité et/ou assez fort et/ou comportent de l'oxyde du métal qui diminue la conduction au niveau de la zone de collage.

On connaît également par le document **[4]** un procédé permettant d'obtenir une couche enterrée de siliciure de cobalt sous un film mince de silicium. La couche enterrée de siliciure de cobalt est obtenue en assemblant un substrat de silicium, comportant une couche mince de cobalt et une couche mince de silicium, avec un substrat de silicium implanté, et en faisant ensuite subir un traitement thermique à l'assemblage. La couche de cobalt réagit alors avec la couche mince de silicium en formant du siliciure de cobalt. L'inconvénient de ce procédé est qu'il ne permet pas d'améliorer la conduction au niveau de l'interface de collage entre les deux substrats.

### EXPOSÉ DE L'INVENTION

Le but de l'invention est de fournir un procédé d'assemblage de deux substrats dont l'un au moins supporte une couche électriquement conductrice, par exemple formée d'un ou plusieurs films métalliques ou en alliage conducteur comme en siliciure d'un métal ou encore en germaniure d'un métal, ledit procédé ne possédant pas les inconvénients de l'art antérieur et en particulier, permettant d'améliorer la conduction au niveau de l'interface de collage.

Ce but est atteint par un procédé d'assemblage par adhésion moléculaire d'un premier substrat et d'un deuxième substrat selon des faces de contact, la face de contact du premier substrat présentant une couche électriquement conductrice sur au moins une partie de sa surface, le procédé comprenant les étapes suivantes :
- dépôt d'une couche de liaison sur au moins une partie de la couche électriquement conductrice, ladite couche de liaison étant apte à assurer une adhésion moléculaire avec une zone de la face de contact du deuxième substrat et apte à se combiner avec la couche électriquement conductrice pour former un alliage conducteur,
- mise en contact et collage par adhésion moléculaire de la couche de liaison du premier substrat avec la zone de la face de contact du deuxième substrat,
- transformation, sur tout ou partie de son épaisseur, de tout ou partie de la couche électriquement conductrice avec tout ou partie de la couche de liaison et avec au moins une partie de l'épaisseur de la zone de la face de contact sur tout ou partie de la surface du deuxième substrat pour former une zone d'alliage(s) conducteur(s).

La couche électriquement conductrice est donc apte à se combiner avec la couche de liaison, ainsi qu'avec la zone de la face de contact du deuxième substrat pour former un ou plusieurs alliages conducteurs constituant une zone d'alliage(s) conducteur(s) s'étendant de part et d'autre de l'interface de collage. L'invention permet ainsi de rendre conductrice la zone autour de l'interface de collage. On entend par « interface de collage » la zone de contact entre les faces de contact des substrats (avec ou sans les couches de liaison) lors de l'assemblage des substrats par adhésion moléculaire.

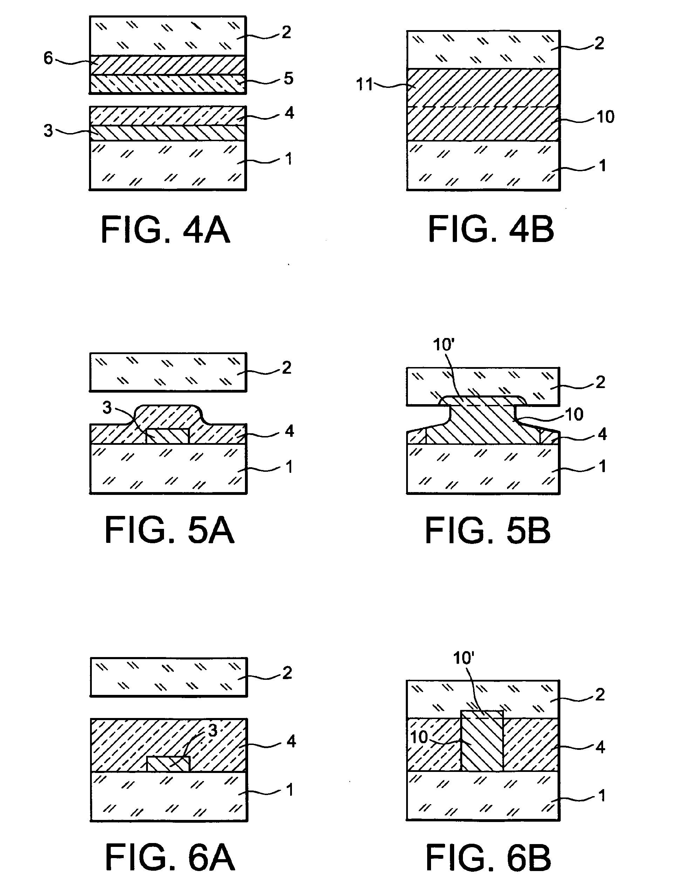

L'expression « tout ou partie » est à comprendre dans le plan des couches en contact, à savoir dans le plan de la couche de matériau électriquement conducteur et dans le plan de la couche de liaison, et non sur l'épaisseur de ces couches. En effet, selon l'invention, la totalité de l'épaisseur des couches de liaison est transformée en matériau alliage (la couche électriquement conductrice n'est pas, quant à elle, nécessairement intégralement consommée). Mais si, par exemple, la couche de matériau électriquement conducteur est localisé seulement sur une partie de la couche de liaison, alors l'alliage ne se formera que sur une « partie » localisée de la couche de liaison (voir par exemple les figures 5B et 6B commentées ci-dessous).

Notons que lorsqu'on parle de face ou de surface, cette face n'est pas nécessairement faite du même matériau, mais peut être pluri-matériaux.

Avantageusement, l'étape de transformation consiste en un traitement thermique. La température et le temps du traitement thermique sont choisis en fonction du ou des l'alliage(s) souhaité (s) et de la quantité d'alliage que l'on veut obtenir. En particulier, le temps du traitement thermique peut être adapté pour faciliter l'interaction de la couche électriquement conductrice déposée sur un premier substrat avec une partie superficielle du second substrat. En effet, l'affinité entre le matériau de la couche de liaison et le matériau de la couche électriquement conductrice pour former un alliage détermine la température à laquelle la structure doit être portée pour permettre la constitution de l'alliage. De façon combinée ou alternative, cette étape de transformation peut comporter une étape de mise sous pression ou une étape d'électromigration connues de l'homme du métier pour former un alliage.

Les substrats peuvent être en n'importe quel matériau. Ils peuvent inclure ou non des niveaux processés. Ce peut être également un ensemble de pistes sur un isolant. Le premier substrat peut être un circuit de lecture CMOS, CCD... présentant en surface des plots de contact. Ce circuit peut avoir en surface une topologie... Le deuxième substrat peut être par exemple un matériau photodétecteur ou photoémetteur ou une structure multicouche (diode...).

Selon un premier mode de réalisation, le procédé d'assemblage comprend en outre, avant l'étape de mise en contact et de collage, une étape de formation de la zone de la face de contact du deuxième substrat par dépôt d'une couche de liaison apte à assurer une adhésion moléculaire avec la couche de liaison du premier substrat et apte à réagir avec la couche électriquement conductrice déposée sur le premier substrat pour former un alliage conducteur. L'étape de mise en contact et de collage par adhésion moléculaire se fait donc entre la couche de liaison du premier substrat et la couche de liaison comprise sur la face de contact du deuxième substrat.

Avantageusement, la couche de liaison du premier substrat et la couche de liaison du deuxième substrat sont en un même matériau. On obtient ainsi une zone d'alliage uniforme du point de vue de sa composition.

Selon un deuxième mode de réalisation, le procédé d'assemblage comprend en outre, avant l'étape de mise en contact et de collage, une étape de formation de la zone de la face de contact du deuxième substrat par dépôt d'une couche électriquement conductrice recouverte au moins en partie d'une couche de liaison apte à assurer une adhésion moléculaire avec la couche de liaison du premier substrat et apte à se combiner, au cours de l'étape de transformation, avec ladite couche électriquement conductrice du deuxième substrat pour former un alliage conducteur. Ici, la face de contact du deuxième substrat comprend une couche de liaison sur une couche électriquement conductrice ; l'étape de mise en contact et de collage par adhésion moléculaire se fait donc entre la couche de liaison du premier substrat et la couche de liaison formée sur la face de contact du deuxième substrat. On peut ainsi réaliser une structure résultant de l'assemblage de deux substrats comportant chacun une couche électriquement conductrice sur laquelle est formée une couche de matériau déterminé servant de couche de liaison.

Avantageusement, l'épaisseur de la couche de liaison du premier et/ou du deuxième substrat et l'épaisseur de la couche de matériau électriquement conducteur du premier et/ou du deuxième substrat, ainsi que la durée du traitement thermique (temps du recuit) sont adaptés de façon à ce que les alliages conducteurs créés soient situés au niveau et/ou autour de l'interface de collage des substrats.

Avantageusement, la couche électriquement conductrice située sur la zone de la face de contact du deuxième substrat est également apte à se combiner, au cours de l'étape de transformation, avec ledit matériau de la couche de liaison située sur le premier substrat pour former un alliage conducteur compris dans la zone d' alliage (s) .

Avantageusement, la couche de liaison du premier substrat et la couche de liaison du deuxième substrat sont en un même matériau et la couche électriquement conductrice du premier substrat et la couche électriquement conductrice du deuxième substrat sont en un même matériau.

Avantageusement, la couche électriquement conductrice du premier substrat et/ou du deuxième substrat est formée d'un empilement d'un ou plusieurs films en un métal ou en alliage conducteur. Parmi les métaux, on peut citer le nickel Ni, le platine Pt, le palladium Pd, le cobalt Co, le tungstène W, le tantale Ta, le titane Ti, le vanadium V, le chrome Cr, le manganèse Mn, le fer Fe, le molybdène Mo ou un mélange de ces éléments. Comme alliage conducteur, on peut citer les siliciures ou les germaniures de ces métaux et, de manière générale, tout matériau électriquement conducteur apte à former des alliages conducteurs avec les matériaux des couches de liaison et avec le matériau du deuxième substrat.

Avantageusement, la couche de liaison du premier substrat et/ou du deuxième substrat est en un matériau choisi parmi le silicium, le germanium, le carbure de silicium ou un mélange de ces éléments comme SiGe. La couche de liaison peut également être un empilement de plusieurs couches réalisées avec un ou plusieurs de ces matériaux. De manière générale, la couche de liaison est en un matériau apte à former avec le ou les matériaux de la couche électriquement conductrice un ou plusieurs alliages conducteurs.

Pour être aptes à réaliser un bon collage par adhérence moléculaire, les matériaux de la couche de liaison du premier substrat et/ou du deuxième substrat sont avantageusement choisis selon les possibilités pour l'homme du métier de préparer et de contrôler leur état de surfaces par des techniques classiques de la microélectronique.

Selon un mode réalisation particulier, le procédé comprend en outre, avant l'étape de dépôt de la couche de liaison du premier et/ou du deuxième substrat, une étape de traitement de la surface de la couche électriquement conductrice du premier et/ou du deuxième substrat, destinée à enlever au moins une partie des oxydes et/ou isolants présents à sa surface. Ainsi, la couche de liaison est déposée sur une couche électriquement conductrice dont la surface est dépourvue au moins en partie de tout oxyde et/ou isolant. On évite ainsi la présence de tout oxyde et/ou isolant à l'interface entre la couche électriquement conductrice et la couche de liaison. Ce traitement pourra par exemple être réalisé par une des techniques classiques de gravure utilisées en microélectronique, par exemple par pulvérisation (« sputtering » en anglais), par exemple ionique, et/ou par attaque chimique et/ou par un traitement thermique, sous vide en atmosphère réductrice, ces techniques pouvant être utilisées seules ou en combinaison.

Avantageusement, le procédé comprend en outre, avant l'étape de mise en contact et de collage des faces de contact des deux substrats, une étape de traitement de surface de la surface de la couche de liaison du premier substrat et de la zone de la face de contact du deuxième substrat.

Avantageusement, ladite étape de traitement de surface consiste en une préparation chimique.

Avantageusement, ce traitement a pour but de supprimer toute contamination particulaire sur la surface de contact des substrats.

Avantageusement, ladite étape de traitement de surface consiste en un traitement conduisant à une surface tout ou partie hydrophobe. Une telle préparation permet de réduire, voire supprimer, l'oxyde présent en surface lors du collage, ce qui favorise la conduction verticale entre les substrats assemblés.

Avantageusement, ladite étape de traitement de surface consiste en un traitement conduisant à une surface tout ou partie hydrophile. Il est avantageux que les deux surfaces de contact des substrats subissent ce traitement de façon à profiter, dès les basses températures, d'un collage par liaisons hydrogènes liées à la présence d'eau en surface, par exemple.

Avantageusement, ladite étape de traitement de surface consiste en un traitement par plasma d'au moins une des surfaces de contact afin d'obtenir une énergie de collage forte à basse température.

Avantageusement, ladite étape de traitement de surface consiste en un traitement par UV et/ou ozone, ou par traitement thermique ou par un traitement en atmosphère contrôlée. Toutes ces techniques peuvent, dans la mesure de leur compatibilité, être utilisées en combinaison.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A et 1B représentent les étapes d'un exemple de réalisation du procédé d'assemblage selon l'invention,
- la figure 2 représente une étape d'un autre exemple de réalisation du procédé d'assemblage selon l'invention,
- les figures 3A et 3B illustrent les étapes d'un autre exemple de réalisation du procédé d'assemblage selon l'invention,
- les figures 4A et 4B illustrent les étapes d'un autre exemple de réalisation du procédé d'assemblage selon l'invention
- les figures 5A et 5B illustrent encore les étapes d'un autre exemple de réalisation du procédé d'assemblage selon l'invention,
- les figures 6A et 6B, 7A et 7B illustrent encore les étapes d'autres exemples de réalisation du procédé d'assemblage selon l'invention,
- les figures 8A à 8I illustrent les étapes d'un autre exemple de réalisation du procédé d'assemblage selon l'invention.

Il faut noter que les dimensions des couches et des substrats dans ces figures ne sont pas représentées à l'échelle.

### EXPOSÉ DÉTAILLÉ DE MODES DE RÉALISATION PARTICULIERS

Nous allons à présent détailler le mode de réalisation de plusieurs structures réalisées selon le procédé de l'invention.

Nous allons tout d'abord réaliser une structure résultant de l'assemblage d'un substrat de silicium avec un autre substrat de silicium comportant une couche de métal en nickel. On commence par déposer une couche de nickel 3 sur un substrat de silicium 1. Le dépôt de la couche de nickel peut être réalisée selon une technique classique de dépôt connue de l'homme de l'art, par exemple par pulvérisation. L'épaisseur de la couche 3 déposée est de quelques nanomètres à quelques micromètres. Puis, on dépose une couche de liaison 4 sur la couche de Ni 3 ; cette couche de liaison 4 peut être en silicium amorphe. L'épaisseur de la couche 4 de silicium amorphe sera, par exemple, de l'ordre de grandeur de la moitié de l'épaisseur de la couche de Ni 3 précédemment déposée. Pour éviter la présence de tout oxyde à l'interface entre la couche de Ni 3 et la couche de Si amorphe 4, on effectue de préférence une attaque préalable de la surface de la couche de Ni. Cette attaque pourra par exemple être réalisée par pulvérisation, par exemple ionique. Il est préférable de réaliser cette pulvérisation sous vide dans le même bâti que celui utilisé pour le dépôt du Si amorphe afin d'éviter toute remise à l'air ou exposition à l'oxygène entre ces deux étapes.

L'ensemble constitué du substrat de silicium 1, de la couche de nickel 3 et de la couche de silicium amorphe 4 subit ensuite un nettoyage chimique de manière à supprimer toute contamination particulaire, en particulier au niveau de la surface de contact pour le collage avec un autre substrat 2. Par exemple, on peut plonger cet ensemble dans une solution de (NH₄OH : H₂O₂ : H₂O). On rend ainsi les surfaces à assembler hydrophiles.

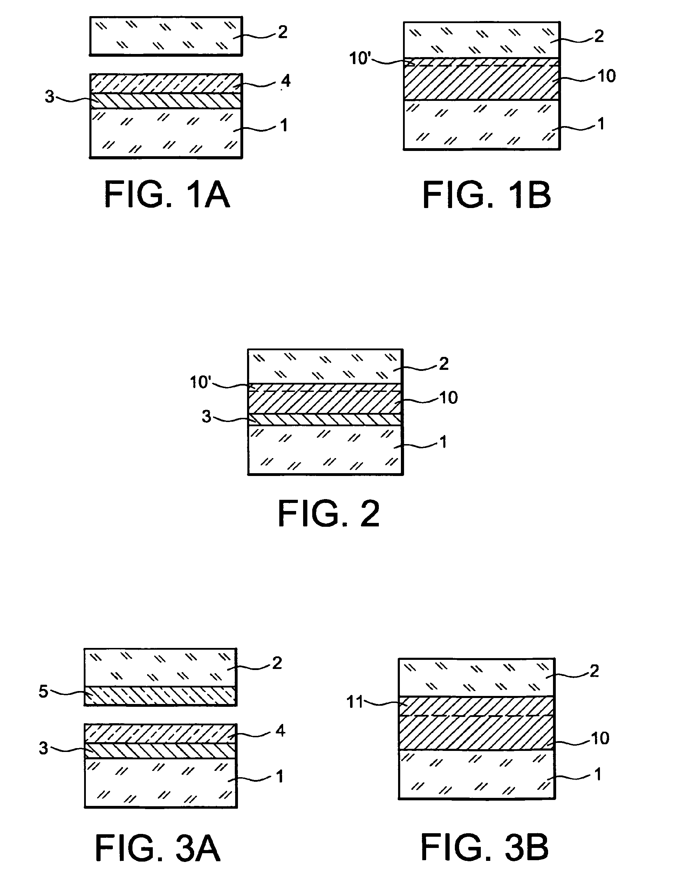

Puis, la couche de silicium amorphe de cet ensemble est mise en contact et collée par adhésion moléculaire sur la surface d'un deuxième substrat 2, par exemple un substrat de silicium (voir figure 1A). L'adhésion moléculaire est une technique d'assemblage bien connue de l'homme du métier. Ce collage peut être effectué à température ambiante ou plus élevée, et il peut être ou non assisté par l'application de vide partiel ou de pression sur l'assemblage.

Enfin, la structure ainsi réalisée est soumise à un traitement thermique de façon à faire réagir ensemble tout (voir figure 1B) ou partie (voir figure 2) de la couche de nickel 3 (couche métallique) avec la couche de silicium amorphe 4 (couche de liaison), ainsi qu'une partie de l'épaisseur du deuxième substrat 2. On obtient une zone d'alliage formée d'un alliage 10 provenant de la réaction de la couche de liaison 4 avec la couche métallique de nickel 3 et d'un alliage 10' provenant de la réaction d'une partie superficielle du deuxième substrat 2 avec la couche métallique de nickel 3. On rappelle que les couches ne sont pas représentées à l'échelle sur les figures. Sur la figure 1B, la couche 3 est intégralement consommée. Sur la figure 2, elle n'est consommée que partiellement en épaisseur. Dans le cas présent, comme la couche de liaison 4 et le deuxième substrat 2 sont en silicium, on obtient un seul et même alliage de siliciure. On notera que dans la figure 1B, ainsi que dans les figures 3B, 4B, 5B, 6B, 7B et 8H, on n'a pas représenté de diffusion du matériau conducteur 3 dans le substrat 1 ; on considère par exemple que le substrat 1 comprend en surface une couche barrière à la diffusion du matériau conducteur (non représentée) et sous-jacente à ce dernier. La température et le temps du traitement thermique sont choisis en fonction de la phase de siliciure souhaitée et de la quantité de siliciuration que l'on veut induire. On peut en effet arrêter le traitement thermique avant que la totalité de l'épaisseur de la couche métallique ne se soit transformée en alliage. Par exemple, pour obtenir un alliage de phase siliciure NiSi, le traitement thermique sera réalisé à une température supérieure à 350°C, par exemple à 450°C. La durée du traitement thermique pourra être comprise entre 1 minute et 10 heures pour permettre la formation de NiSi d'une épaisseur de quelques nanomètres à quelques micromètres pour une couche de silicium amorphe de quelques nanomètres à quelques micromètres. Si on utilise du palladium Pd à la place du Nickel, un temps d'environ 15 minutes à une température de 275°C environ permet de générer environ 142 nanomètres de Pd₂Si à partir d'une couche de 100 nanomètres de Pd et de 68 nanomètres de Si. Il faut pour ces évaluations tenir compte également du fait que l'épaisseur du siliciure obtenu dépend de la nature des matériaux considérés formant l'alliage.

Pour que la zone d'alliages englobe à terme l'interface de collage, il n'est pas nécessaire d'avoir le même matériau des deux côtés de cette interface de collage. Le matériau de la couche de liaison 4 supportée par le premier substrat et le matériau de la couche de liaison 5 supportée par le deuxième substrat ou celui du deuxième substrat lui-même sont choisis par rapport au matériau de la couche de matériau conducteur 3 du premier substrat.

Nous allons donner quelques exemples dans lesquels l'abréviation M1 se rapporte à la couche de matériau conducteur 3 du premier substrat, l'abréviation L1 se rapporte à la couche de liaison 4 du premier substrat et l'abréviation L2 se rapporte à une partie superficielle du deuxième substrat ou à sa couche de liaison 5 lorsqu'il en contient une.

Par exemple, pour M1 en un matériau choisit parmi Ni, Co, Pt, Pd, Ti..., on peut choisir L1 et L2 en silicium.

Si, par exemple, on choisit M1 en nickel ou en cobalt, L1 peut être en silicium et L2 en germanium ; la transformation thermique sera effectuée à une température compatible pour obtenir un siliciure et un germaniure ; par exemple, dans le cas d'une couche M1 en nickel, la température sera choisie avantageusement supérieure à 350°C et par exemple à 400°C.

Pour être sûr que la réaction de transformation en alliage (par exemple une réaction de siliciuration) se fasse également au-delà de l'interface de collage, il faut que l'épaisseur de la couche de matériau conducteur 3 (M1) soit suffisante. Le choix de l'épaisseur de la couche (M1) se fait en tenant compte :
- de la réaction de transformation à induire entre la couche (M1) et la couche de liaison (L1) d'une part, et entre la couche (M1) et la couche de liaison (L2) ou du deuxième substrat 2 d'autre part,
- de l'épaisseur de la couche de liaison (L1),
- de la nature du premier substrat 1 sur lequel cette couche (M1) est déposée, si cette couche M1 est apte à réagir avec le premier substrat 1,
- de la nature du support (L2), que ce soit le deuxième substrat 2 ou la couche de liaison 5 déposée sur ce deuxième substrat,
- de l'épaisseur de la couche L2 à faire réagir,
- de la présence ou non sur le deuxième substrat 2 d'une couche métallique elle-même participant à la formation de la zone d'alliage.

Pour une réaction de siliciuration, les rapports de l'épaisseur de Si consommé en fonction de l'épaisseur de métal consommé sont présentés dans le tableau 1 ci-dessous pour différents siliciures formés.

**Tableau 1**

| Siliciure formé | Ni₂Si | NiSi | NiSi₂ | Pd₂Si | PdSi | Co₂Si | CoSi | CoSi₂ |
|---|---|---|---|---|---|---|---|---|
| Rapport | 0,91 | 1,83 | 3,65 | 0,68 | 1,36 | 0,91 | 1,82 | 3,64 |

Sur un premier substrat 1 en silicium, on dépose une couche de nickel 3 (M1) d'une épaisseur de X nm, ainsi qu'une couche de liaison 4 (L1) en silicium de 18,3 nm d'épaisseur. Cet empilement est assemblé par adhésion moléculaire sur un deuxième substrat 2 supportant une couche de liaison de 100 nm de silicium (voir par exemple les figures 1A, 1B et 2).

Comme la couche de liaison 4 (L1) est de même nature que le premier substrat 1, on peut considérer que la réaction interviendra « au dessus » et au « dessous » de la couche de matériau conducteur 3 (M1).

On décide qu'on veut obtenir un alliage NiSi. Dans ce cas, on va consommer environ autant de silicium dans le premier substrat 1 que dans la couche de liaison 4 (L1) et dans la partie supérieure du deuxième substrat (L2). Par exemple, on considère qu'une épaisseur superficielle de 9,15 nm est transformée en alliage dans le deuxième substrat. La consommation de silicium « au dessus » est donc de (18,3 + 9,15) nm. Au total, on aura une consommation de silicium (S1+L1+L2) de (18,3 nm x 2 + 9,15 x 2), soit environ 55 nm. On a donc une consommation de 55 nm / 1,83 de nickel, soit environ 30 nm. On doit donc déposer une couche de nickel d'épaisseur au moins égale à X=30 nm.

Pour que la réaction de siliciuration atteigne l'interface de collage mais ne la traverse pas, on ne compte pas de consommation dans le deuxième substrat (couche superficielle L2), ni ce qui aurait été consommé dans le premier substrat pendant la réaction avec L2. L'épaisseur de la couche de nickel dans notre exemple est donc de (18,3 x 2)/1,83 = 20 nm. Par conséquent, pour que l'alliage soit présent au niveau et autour de l'interface de collage, il faut que la couche de nickel ait une épaisseur minimale supérieure à 20 nm.

Selon un autre exemple, si le premier substrat 1 n'est pas en silicium mais en un matériau qui ne réagit pas avec la couche de nickel (par exemple, le substrat comporte une couche barrière à la diffusion du nickel dans le substrat), alors, pour que l'alliage soit présent au niveau et autour de l'interface de collage, il faut que la couche de nickel est une épaisseur minimale supérieure à 10 nm (soit 18,3/1,83).

On pourra se rapporter aux tables publiées dans la littérature pour obtenir les valeurs des rapports pour d'autres réactions.

Selon une variante illustrée dans les figures 3A et 3B, le deuxième substrat 2 est également recouvert d'une couche de liaison 5 de Silicium amorphe avant d'être assemblé par collage avec l'ensemble constitué du substrat de Silicium 1, de la couche de Ni 3 et de la couche de Si amorphe 4 (figure 3A). Cette variante peut par exemple être utilisée lorsque le deuxième substrat n'est pas compatible avec la formation de la zone d'alliage(s) pour permettre la « traversée » de l'interface de collage. On peut choisir ici par exemple d'obtenir une structure d'assemblage dans laquelle l'épaisseur totale de la couche de liaison de silicium amorphe (c'est-à-dire la couche de Si 4 déposée sur la couche de Ni 3 du premier substrat 1 et la couche de Si 5 déposée sur le deuxième substrat 2) est égale à environ la moitié de l'épaisseur de la couche de Ni 3 déposée sur le premier substrat 1. On procède ensuite au traitement thermique de façon à faire réagir ensemble la couche de silicium amorphe 4 avec la couche de nickel 3 et avec la couche de silicium amorphe 5. On obtient alors un assemblage présentant deux alliages 11 et 10 entre le premier substrat 1 et le deuxième substrat 2, les deux alliages étant ici des alliages de siliciure (figure 3B).

Selon une autre variante illustrée dans les figures 4A et 4B, on peut réaliser une structure résultant de l'assemblage de deux ensembles, chacun desdits ensemble comprenant un substrat de silicium 1, 2 recouvert d'une couche de Ni 3, 6 et d'une couche de silicium amorphe 4, 5. Après traitement thermique, on obtient deux alliages 10 et 11 de siliciure (figure 4B).

Selon une autre variante également illustrée dans les figures 3A et 3B, une couche de matériau conducteur 3 de 200 nm de nickel est déposée sur un substrat 1 (par exemple en silicium), et cette couche 3 est ensuite recouverte d'une couche de liaison 4 de silicium amorphe d'épaisseur 30 nm. Cet empilement est assemblé sur un deuxième substrat 2 (par exemple en silicium) comportant une couche de liaison 5 de germanium de 50 nm d'épaisseur. Après traitement thermique de cet assemblage à une température de 400°C par exemple, on obtient un assemblage comportant une couche d'alliage de NiSi et une couche d'alliage de NiGe.

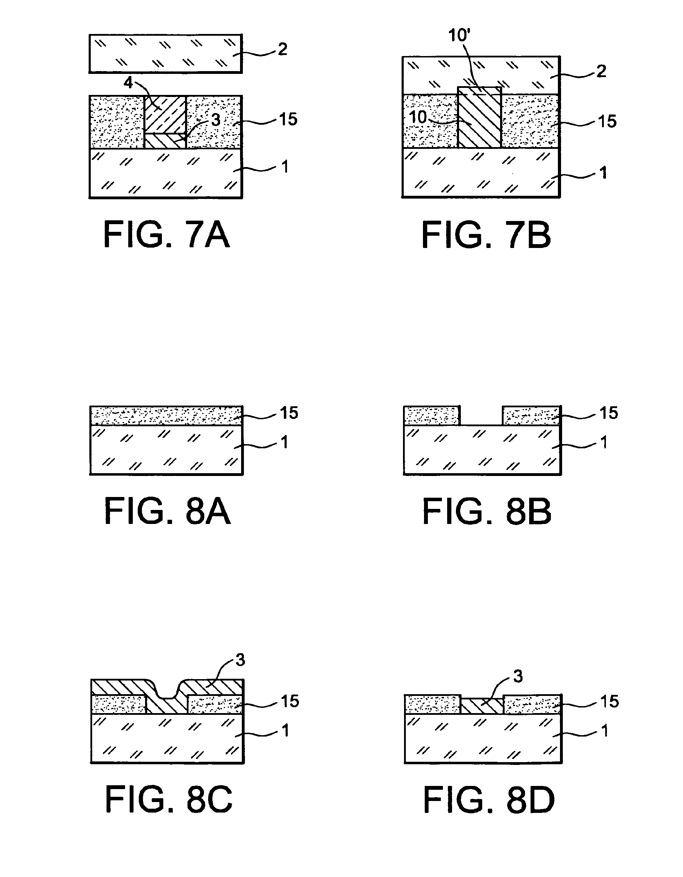

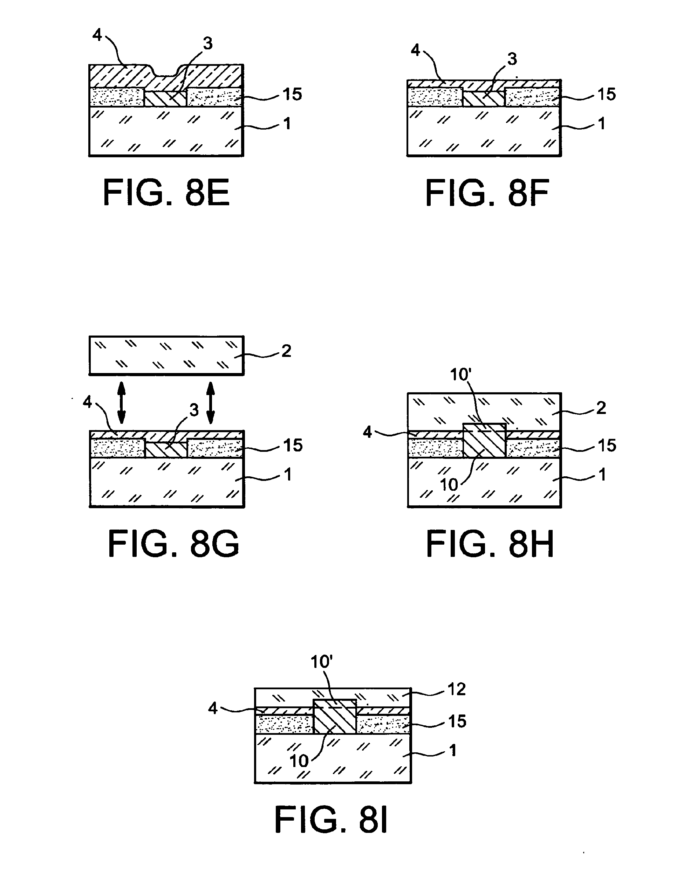

Dans toutes les variantes précédemment décrites, la couche de matériau électriquement conducteur 3, 6 recouvre tout le substrat de silicium 1, 2. Selon d'autres variantes, cette couche de matériau électriquement conducteur peut également n'être présente que localement sur le substrat 1, 2 (voir les figures 5A et 6A). Ce sera le cas par exemple si l'on considère les plots de connexion d'un substrat CMOS. Dans ce cas, la face à assembler pourra comporter une topographie de surface ou un ensemble de matériaux de natures différentes, dont certains isolants ou inaptes à réagir avec le conducteur M1. Parmi les isolants, on citera SiO₂, Si₃N₄, Al₂O₃, AlN, le diamant, SiC..., variante illustrée par les figures 7A et 7B (le matériau isolant est noté 15 sur les figures). Le matériau 15 peut être identique à L1 initialement et avoir subi des traitements le rendant inapte localement à réagir avec M1. Un exemple consiste à déposer sur un substrat 1 (S1), par exemple de silicium, un film 15 de SiO₂, par exemple d'épaisseur 120 nm (voir figure 8A) ; par lithographie et gravure, classiques en microélectronique, on « ouvre » des zones, par exemple de quelques micromètres carrés à quelques millimètres carrés dans le film 15 (voir figure 8B). On dépose alors un film 3 (M1), par exemple de nickel, et par exemple de 100 nm d'épaisseur (figure 8C). Un procédé de polissage mécano-chimique, classique en microélectronique, permet de supprimer les zones de film 3 de nickel à l'aplomb des zones de SiO₂ non gravées (figure 8D). On peut alors déposer une couche de liaison 4 (L1), à la fois sur les zones 15 de SiO₂ et sur les zones 3 (M1), par exemple en silicium amorphe, d'une épaisseur par exemple de 100 nm (figure 8E). La topologie de surface peut être rendue plane par un procédé de polissage mécano-chimique, laissant une épaisseur de la couche 4 (L1) de silicium amorphe aussi fine que souhaitable, par exemple 20 nm, à l'aplomb des zones 15 de SiO₂, voire nulle (voir figure 8F). Le procédé de polissage utilisé assure une planéité de surface apte à un collage moléculaire ultérieur avec un substrat 2 (S2), par exemple de silicium, par exemple d'un type (N ou P) ou d'un dopage différent du substrat 1 (S1) (figure 8G). Un traitement thermique, par exemple à 400°C, permet de former la phase siliciure 10, 10' NiSi avec traversée de l'interface de collage (voir alliage 10') (assurée en particulier en limitant l'épaisseur de la couche de liaison 4 (L1) après l'étape de planarisation (figure 8F)) et localisation de la conduction (en particulier dans les zones d'alliage 10 et 10' encadrées par les zones isolantes 15) (voir figure 8H). Ultérieurement, un amincissement d'une des plaques (ici le substrat 2) permet d'obtenir un film mince 12 à zones de conduction verticales 10, 10' et à zones isolées 15 par rapport au support 1 (voir figure 8I). L'amincissement peut être réalisé par exemple par amincissement mécanique, chimiques ou même être induit par fracture induite avant ou après le traitement de formation de l'alliage au niveau d'une zone fragile enterrée créée dans un des deux substrats (le substrat à amincir) par exemple par implantation, par exemple par des espèces gazeuses.

Selon un autre exemple, pour réaliser l'assemblage du substrat 1 (de type CMOS) avec un autre substrat 2, on peut déposer une couche de liaison 4 sur la couche localisée de matériau électriquement conducteur 3 (plot de connexion) (figure 5A). Puis, on réalise un traitement thermique de manière à ce que le matériau électriquement conducteur 3 et la couche de liaison 4 forme un alliage 10, ainsi qu'un alliage 10' provenant de la réaction de la couche de matériau conducteur 3 avec une partie du substrat 2 comprenant ou non une couche de liaison L2 localisée (figure 5B). Dans cette variante, l'alliage 10 n'occupe pas la totalité de la surface des substrats 1 et 2 comme dans les exemples précédents.

On peut également déposer la couche de liaison 4 avec une épaisseur suffisante pour permettre après polissage, par exemple mécano-chimique, d'obtenir une surface de couche de liaison 4 à assembler relativement plane (figure 6A). La localisation du contact électrique entre les deux substrats 1, 2 au niveau de la couche localisée électriquement conductrice 3 pourra être obtenue par les techniques suivantes prises seules ou en combinaison : gravure, implantation, chauffage localisé (par exemple recuit laser avant collage ou après, si un des substrats est transparent). On obtient alors un assemblage de deux substrats 1, 2 via un alliage 10 au milieu d'une couche de liaison 4 et comprenant également un alliage 10' provenant de la réaction de la couche de matériau conducteur 3 avec une partie du substrat 2 comprenant ou non une couche localisée L2 (figure 6B). Toutes les variantes décrites précédemment concernant le deuxième substrat 2 recouvert ou non d'une couche de matériau électriquement conducteur 6 et/ou d'une couche de liaison 5 s'applique également.

Selon une autre variante, la surface des substrats, comportant ou non une couche de liaison de matériau déterminé, est préparée par une technique la rendant hydrophobe. Par exemple, pour préparer la surface d'un substrat comportant une couche de liaison de silicium amorphe, on peut utiliser un nettoyage dit « d'attaque HF finale ». La dilution de l'acide fluorhydrique HF peut par exemple être comprise dans la gamme [1‰-49%]. Cet acide peut être utilisé en phase liquide ou avantageusement en phase vapeur pour diminuer la densité de particules en surface. En variante, on peut rendre la surface de silicium amorphe hydrophobe par un traitement plasma, par exemple riche en hydrogène. On peut également effectuer un traitement thermique, par exemple sous hydrogène à une température inférieure à celle induisant une réaction entre la couche conductrice et la couche de liaison ou, si cette température est supérieure à la température induisant la réaction entre la couche conductrice et la couche de liaison, de sorte que pendant le temps de traitement la réaction engendrée n'affecte par la surface de collage, la siliciuration n'étant que partielle et enterrée. On peut pour cela jouer sur le temps de réaction. L'ensemble constitué du substrat et de la couche de Si amorphe est ensuite collé sur la surface d'un substrat suivant une des variantes décrites précédemment.

Selon une variante des exemples précédents, la couche de liaison en silicium est réalisée par une méthode de dépôt (par exemple par pulvérisation) qui lui donne un caractère polycristallin. Dans ce cas, le choix du siliciure à obtenir devra tenir compte de la température de dépôt du silicium polycristallin : si le dépôt du silicium polycristallin est réalisé à une température de 600°C, alors on ne pourra envisager que des siliciures ayant une température d'élaboration supérieure à 600°C, par exemple le siliciure NiSi₂ obtenu d'après la littérature pour un température supérieure à 750°C.

Bien que les exemples donnés plus haut présentent tous des structures obtenues avec une couche métallique de nickel, il est bien entendu qu'on peut utiliser une couche en tout autre matériau électriquement conducteur, des métaux comme par exemple une couche en palladium, en platine, en cobalt, en tungstène, en tantale, en titane, en vanadium, en chrome, en manganèse, en fer, en molybdène, en un mélange de ces éléments ou encore en un alliage conducteur (par exemple en siliciure ou en germaniure de ces métaux). Par exemple, en collant deux substrats comportant une couche de Ni₂Si (couche de matériau électriquement conducteur) sous une couche de silicium amorphe et en traitant la structure ainsi obtenue à une température supérieure à 350°C, on peut former une couche d'alliage conducteur NiSi.

De même, on peut utiliser une couche de liaison en un matériau autre que le silicium amorphe ou polycristallin. On peut par exemple obtenir une structure comportant une couche d'alliage de germaniure en déposant une couche de liaison en germanium. De même qu'avec les siliciures des exemples précédents, l'épaisseur de la couche de liaison en germanium à déposer dépend de la quantité de germaniure que l'utilisateur veut former par réaction avec le métal enfoui (c'est-à-dire la couche de matériau métallique). En effet, la réaction de formation de l'alliage est contrôlée par la température du traitement thermique utilisé, qui détermine la nature de l'alliage obtenu, et par le temps du traitement thermique, qui détermine l'épaisseur de l'alliage formé en fonction de la diffusion des matériaux mis en jeu. Par exemple, en collant deux substrats comportant une couche de cuivre (couche métallique) sous une couche de germanium (couche de liaison) et en traitant la structure ainsi obtenue à une température supérieure à 400°C, on peut former une couche d'alliage de germaniure Cu₃Ge. On peut citer également comme matériau de liaison SiGe ou SiC ; un empilement de ces matériaux est également possible.

Le procédé selon l'invention permet d'obtenir une structure dans laquelle on peut contrôler la conduction électrique à l'interface des deux substrats assemblés. En effet, selon notre invention, des moyens sont mis en oeuvre afin que l'alliage conducteur « franchisse » l'interface de collage entre le premier substrat et le deuxième substrat. On optimise la conduction au niveau de la zone de collage en utilisant des matériaux et des épaisseurs adaptées pour les couches de liaison et on choisit des matériaux électriquement conducteurs qui sont fonctions entre autres des substrats à assembler.

Avantageusement, l'épaisseur de la couche de liaison, l'épaisseur de la couche métallique et le temps de traitement thermique sont adaptés de manière à ce que la phase d'alliage soit induite au niveau et autour de l'interface de collage des substrats. Une telle démarche permet d'induire par exemple une conduction électrique verticale ohmique de bonne qualité au niveau et autour de l'interface de collage.

Par ailleurs, dans le cas où seul un substrat comporte une couche de métal, il est avantageux de faire diffuser le métal vers l'autre substrat de manière à induire une réaction de formation d'un alliage conducteur (par exemple un siliciure) et ainsi induire une conduction électrique verticale ohmique de bonne qualité au niveau et autour de l'interface de collage.

Avantageusement, on évite également la création d'oxyde ou de tout autre couche « barrière » au niveau des faces à assembler qui pourrait gêner le franchissement de l'interface par l'alliage (par exemple, en faisant subir une préparation donnant un caractère, tout ou partie, hydrophobe aux surfaces des faces des substrats à assembler).

Pour finir, le tableau 2 ci-dessous présente quelques exemples de siliciures formés selon le procédé de l'invention à l'aide d'une couche de métal X déterminé (X= Ni, Pt, Co ou Pd) ou d'un siliciure (SiX) et une couche de liaison en silicium. Ce tableau reprend également les valeurs actuellement publiées des températures de traitement thermique à effectuer pour obtenir tel ou tel siliciure.

**Tableau 2**

| Métal | Siliciures / T(°C) de formation | Siliciures / T(°C) de formation | Siliciures / T(°C) de formation |
|---|---|---|---|
| Ni | Ni₂Si / ≥ 200°C | NiSi / ≥ 350°C | NiSi₂ / ≥ 750°C |
| Pt | Pt₂Si / ≥ 200°C | PtSi / ≥ 300°C | |
| Co | CoSi / ≥ 350°C | CoSi₂ / ≥ 550°C | |
| Pd | Pd₂Si / ≥ 200°C | PdSi / ≥ 800°C | |

Dans les exemples précédemment décrits, on a évoqué uniquement la formation d'alliage binaire. Bien entendu, des alliages ternaire, quaternaire (et plus) peuvent être envisagés sans sortir du cadre de la présente invention. Ce pourra être le cas par exemple si on utilise une couche électriquement conductrice multi métal...

### BIBLIOGRAPHIE

[1] B. Aspar et al, "Smart-Cut process using metallic bonding : Application to transfer of Si, GaAs, InP thin films", Electronics Letters, 10th June 1999, Vol. 35, No. 12.
[2] G. Thungström et al., Physica Scripta, T 54, p 77-80, 1994.
[3] A. Shigetou, "Room Temperature Bonding of UltraFine Pitch and Low-Profiled Cu Electrodes for Bump-Less interconnect", Electronic Components and Technology Conference, 2003.
[4] Shiyang Zhu et al., "Buried cobalt silicide layer under thin silicon film fabricated by wafer bonding and hydrogen-induced delamination techniques", Journal of the electrochemical society, Electrocemical Society Manchester, New Hampshire, US, vol. 146, n°7, juillet 1999, pages 2712-2716.

## Revendications

1. Procédé d'assemblage par adhésion moléculaire d'un premier substrat (1) et d'un deuxième substrat (2) selon des faces de contact, la face de contact du premier substrat (1) présentant une couche électriquement conductrice (3) sur au moins une partie de sa surface, le procédé comprenant les étapes suivantes :
- dépôt d'une couche de liaison (4) sur au moins une partie de la couche électriquement conductrice (3), ladite couche de liaison (4) étant apte à assurer une adhésion moléculaire avec une zone de la face de contact du deuxième substrat (2) et apte à se combiner avec la couche électriquement conductrice (3) pour former un alliage conducteur (10),
- mise en contact et collage par adhésion moléculaire de la couche de liaison (4) du premier substrat (1) avec la zone de la face de contact du deuxième substrat (2),
- transformation, sur tout ou partie de son épaisseur, de tout ou partie de la couche électriquement conductrice (3) avec tout ou partie de la couche de liaison (4) et avec au moins une partie de l'épaisseur de la zone de la face de contact sur tout ou partie de la surface du deuxième substrat pour former une zone d'alliage(s) conducteur (s) .

2. Procédé d'assemblage selon la revendication précédente, **caractérisé en ce que** l'étape de transformation consiste en un traitement thermique.

3. Procédé d'assemblage selon la revendication 1 ou 2, **caractérisé en ce que** l'étape de transformation consiste en une étape de mise sous pression ou une étape d'électromigration pour former un alliage.

4. Procédé d'assemblage selon l'une quelconque des revendications précédentes, **caractérisé en ce qu'**il comprend en outre, avant l'étape de mise en contact et de collage, une étape de formation de la zone de la face de contact du deuxième substrat (2) par dépôt d'une couche de liaison (5) apte à assurer une adhésion moléculaire avec la couche de liaison (4) du premier substrat (1) et apte à réagir avec la couche électriquement conductrice déposée sur le premier substrat pour former un alliage conducteur.

5. Procédé d'assemblage selon la revendication précédente, **caractérisé en ce que** la couche de liaison (4) du premier substrat (1) et la couche de liaison (5) du deuxième substrat (2) sont en un même matériau.

6. Procédé d'assemblage selon l'une quelconque des revendications 1 à 3, **caractérisé en ce qu'**il comprend en outre, avant l'étape de mise en contact et de collage, une étape de formation de la zone de la face de contact du deuxième substrat (2) par dépôt d'une couche électriquement conductrice (6) recouverte au moins en partie d'une couche de liaison (5) apte à assurer une adhésion moléculaire avec la couche de liaison (4) du premier substrat (1) et apte à se combiner, au cours de l'étape de transformation, avec ladite couche électriquement conductrice (6) du deuxième substrat (2) pour former un alliage conducteur (11).

7. Procédé d'assemblage selon la revendication précédente, **caractérisé en ce que** la couche électriquement conductrice (6) située sur la zone de la face de contact du deuxième substrat (2) est également apte à se combiner, au cours de l'étape de transformation, avec ledit matériau de la couche de liaison (4) située sur le premier substrat (1) pour former un alliage conducteur (10) compris dans la zone d'alliage(s).

8. Procédé d'assemblage selon la revendication 6 ou 7, **caractérisé en ce que** la couche de liaison (4) du premier substrat (1) et la couche de liaison (5) du deuxième substrat (2) sont en un même matériau et **en ce que** la couche électriquement conductrice (3) du premier substrat (1) et la couche électriquement conductrice (6) du deuxième substrat (2) sont en un même matériau.

9. Procédé d'assemblage selon l'une quelconque des revendications précédentes, **caractérisé en ce que** la couche électriquement conductrice (3,6) du premier substrat (1) et/ou du deuxième substrat (2) est formée d'un empilement d'un ou plusieurs films en un métal ou en alliage conducteur.

10. Procédé d'assemblage selon la revendication précédente, **caractérisé en ce que** le métal est choisi parmi le nickel Ni, le platine Pt, le palladium Pd, le cobalt Co, le tungstène W, le tantale Ta, le titane Ti, le vanadium V, le chrome Cr, le manganèse Mn, le fer Fe, le molybdène Mo ou un mélange de ces éléments.

11. Procédé d'assemblage selon la revendication 9, **caractérisé en ce que** l'alliage conducteur est choisi parmi les siliciures ou les germaniures du nickel Ni, du platine Pt, du palladium Pd, du cobalt Co, du tungstène W, du tantale Ta, du titane Ti, du vanadium V, du chrome Cr, du manganèse Mn, du fer Fe ou du molybdène Mo.

12. Procédé d'assemblage selon l'une quelconque des revendications 1 à 9, **caractérisé en ce que** la couche de liaison (4,5) du premier substrat (1) et/ou du deuxième substrat (2) est en un matériau choisi parmi le silicium, le germanium, le carbure de silicium ou un mélange de ces éléments.

13. Procédé d'assemblage selon l'une quelconque des revendications précédentes, **caractérisé en ce qu'**il comprend en outre, avant l'étape de dépôt de la couche de liaison (4,5) du premier (1) et/ou du deuxième substrat (2), une étape de traitement de la surface de la couche électriquement conductrice (3,6) du premier (1) et/ou du deuxième substrat (2), destinée à enlever au moins une partie des oxydes et/ou isolants présents à sa surface.

14. Procédé d'assemblage selon l'une quelconque des revendications précédentes, **caractérisé en ce qu'**il comprend en outre, avant l'étape de mise en contact et de collage des faces de contact des deux substrats, une étape de traitement de surface de la surface de la couche de liaison (4) du premier substrat (1) et de la zone de la face de contact du deuxième substrat (2).

15. Procédé d'assemblage selon la revendication précédente, **caractérisé en ce que** ladite étape de traitement de surface consiste en une préparation chimique.

16. Procédé d'assemblage selon l'une quelconque des revendications 14 ou 15, **caractérisé en ce que** ladite étape de traitement de surface consiste en un traitement conduisant à une surface tout ou partie hydrophobe.

17. Procédé d'assemblage selon l'une quelconque des revendications 14 ou 15, **caractérisé en ce que** ladite étape de traitement de surface consiste en un traitement conduisant à une surface tout ou partie hydrophile.

18. Procédé d'assemblage selon la revendication 14, **caractérisé en ce que** ladite étape de traitement de surface consiste en un traitement par plasma d'au moins une des surfaces de contact afin d'obtenir une énergie de collage forte à basse température.

19. Procédé d'assemblage selon la revendication 14, **caractérisé en ce que** ladite étape de traitement de surface consiste en un traitement par UV et/ou un traitement par ozone et/ou un traitement thermique et/ou un traitement en atmosphère contrôlée.

## Claims

1. Process for assembly of a first substrate (1) and a second substrate (2) on contact faces by molecular bonding, the contact face of the first substrate (1) having an electrically conducting layer (3) on at least part of its surface, the process including the following steps:
- deposition of a bond layer (4) on at least part of the electrically conducting layer (3), said bond layer (4) being capable of achieving molecular bonding with a zone of the contact face of the second substrate (2) and capable of combining with the electrically conducting layer (3) to form a conducting alloy (10),
- contact the bond layer (4) of the first substrate (1) with the zone of the contact face of the second substrate (2) and bond them by molecular bonding,
- transformation over all or part of the thickness of all or part of the electrically conducting layer (3) with all or part of the bond layer (4) and with at least part of the thickness of the zone of the contact face on all or part of the surface of the second substrate to form a zone of conducting alloy(s).

2. Process for assembly according to claim 1, **characterised in that** the transformation step consists of heat treatment.

3. Process for assembly according to claim 1 or 2, **characterised in that** the transformation step consists in a pressurisation step or an electromigration step to form an alloy.

4. Process for assembly according to any one of the previous claims, **characterised in that** it further comprises, before the contacting and bonding step, a step for formation of the zone of the contact face of the second substrate (2) by deposition of a bond layer (5) that can achieve molecular bonding with the bond layer (4) of the first substrate (1) and can react with the electrically conducting layer deposited on the first substrate to form a conducting alloy.

5. Process for assembly according to the previous claim, **characterised in that** the bond layer (4) of the first substrate (1) and the bond layer (5) of the second substrate (2) are made of the same material.

6. Process for assembly according to any one of claims 1 to 3, **characterised in that** it further comprises, before the contacting and bonding step, a step for formation of the zone of the contact face of the second substrate (2) by deposition of an electrically conducting layer (6) covered at least partly by a bond layer (5) capable of achieving molecular bonding with the bond layer (4) of the first substrate (1) and capable of combining during the transformation step with said electrically conducting layer (6) of the second substrate (2) to form a conducting alloy (11).

7. Process for assembly according to claim 6, **characterised in that** the electrically conducting layer (6) located on the zone of the contact face of the second substrate (2) is also capable of combining, during the transformation step, with said material in the bond layer (4) located on the first substrate (1) to form a conducting alloy (10) included in the alloy zone (s) .

8. Process for assembly according to claim 6 or 7, **characterised in that** the bond layer (4) of the first substrate (1) and the bond layer (5) of the second substrate (2) are made of the same material and **in that** the electrically conducting layer (3) of the first substrate (1) and the electrically conducting layer (6) of the second substrate (2) are made of the same material.

9. Process for assembly according to any of claims 1 to 8, **characterised in that** the electrically conducting layer (3, 6) of the first substrate (1) and/or of the second substrate (2) is formed from a stack of one or several films made of metal or conducting alloy.

10. Process for assembly according to claim 9, **characterised in that** the metal is chosen from among nickel Ni, platinum Pt, palladium Pd, cobalt Co, tungsten W, tantalum Ta, titanium Ti, vanadium V, chromium Cr, manganese Mn, iron Fe, molybdenum Mo or a mix of these elements.

11. Process for assembly according to claim 9, **characterised in that** the conducting alloy is chosen from among silicides or germanicides of nickel Ni, platinum Pt, palladium Pd, cobalt Co, tungsten W, tantalum Ta, titanium Ti, vanadium V, chromium Cr, manganese Mn, iron Fe or molybdenum Mo.

12. Process for assembly according to any one of claims 1 to 9, **characterised in that** the bond layer (4,5) of the first substrate (1) and/or of the second substrate (2) is made of a material chosen from among silicon, germanium, silicon carbide or a mix of these elements.

13. Process for assembly according to any one of claims 1 to 12, **characterised in that** it further comprises, before the step to deposit the bond layer (4, 5) of the first (1) and/or of the second substrate (2), a step consisting of surface treatment of the electrically conducting layer (3, 6) of the first (1) and/or of the second substrate (2) to remove at least part of the oxides and/or insulators present on its surface.

14. Process for assembly according to any one of claims 1 to 13, **characterised in that** the process further comprises, before the contracting and bonding step of the contact faces of the two substrates, a surface treatment step of the surface of the bond layer (4) of the first substrate (1) and of the zone of the contact face of the second substrate(2).

15. Process for assembly according to claim 14, **characterised in that** said surface treatment step consists of chemical preparation.

16. Process for assembly according to claim 14 or 15, **characterised in that** said surface treatment step consists of a treatment leading to an entirely or partly hydrophobic surface.

17. Process for assembly according to claim 14 or 15, **characterised in that** said surface treatment step consists of a treatment leading to an entirely or partly hydrophilic surface.

18. Process for assembly according to claim 14, **characterised in that** said surface treatment step consists of a plasma treatment of at least one of the contact surfaces so as to obtain a high bonding energy at low temperature.

19. Process for assembly according to claim 14, **characterised in that** said surface treatment step consists of a UV treatment and/or an ozone treatment and/or a heat treatment and/or a treatment in a controlled atmosphere.

## Patentansprüche

1. Verfahren zum Zusammenfügen eines ersten Substrats (1) und eines zweiten Substrats (2) an Kontaktflächen mittels molekularer Adhäsion, wobei die Kontaktfläche des ersten Substrats (1) eine elektrisch leitende Schicht (3) auf mindestens einem Teil seiner Oberfläche aufweist, wobei das Verfahren die folgenden Schritte umfasst:
- Abscheiden einer Verbindungsschicht (4) auf mindestens einem Teil der elektrisch leitenden Schicht (3), wobei die Verbindungsschicht (4) dazu geeignet ist, eine molekulare Adhäsion mit einem Bereich der Kontaktfläche des zweiten Substrats (2) sicherzustellen, und dazu geeignet ist, sich mit der elektrisch leitenden Schicht (3) zu vereinen, um eine Leiterlegierung (10) zu bilden,
- Inkontaktbringen der Verbindungsschicht (4) des ersten Substrats (1) mit dem Bereich der Kontaktfläche des zweiten Substrats (2) und Verkleben dieser mittels molekularer Adhäsion,
- Umwandlung, auf der gesamten oder einem Teil ihrer Dicke, der gesamten oder eines Teils der elektrisch leitenden Schicht (3) mit der gesamten oder einem Teil der Verbindungsschicht (4) und mit mindestens einem Teil der Dicke des Bereichs der Kontaktfläche auf der gesamten oder einem Teil der Oberfläche des zweiten Substrats, um einen oder mehrere Leiterlegierungsbereiche zu bilden.

2. Zusammenfügungsverfahren nach dem vorhergehenden Anspruch, **dadurch gekennzeichnet, dass** der Umwandlungsschritt in einer Wärmebehandlung besteht.

3. Zusammenfügungsverfahren nach Anspruch 1 oder 2, **dadurch gekennzeichnet, dass** der Umwandlungsschritt in einem Druckbeaufschlagungsschritt oder einem Elektromigrationsschritt besteht, um eine Legierung zu bilden.

4. Zusammenfügungsverfahren nach einem der vorhergehenden Ansprüche, **dadurch gekennzeichnet, dass** es außerdem vor dem Schritt des Inkontaktbringens und Verklebens einen Schritt des Bildens des Bereichs der Kontaktfläche des zweiten Substrats (2) mittels Abscheidung einer Verbindungsschicht (5) umfasst, die dazu geeignet ist, eine molekulare Adhäsion mit der Verbindungsschicht (4) des ersten Substrats (1) sicherzustellen, und dazu geeignet ist, mit der elektrisch leitenden Schicht, die auf dem ersten Substrat abgeschieden wurde, zu reagieren, um eine Leiterlegierung zu bilden.

5. Zusammenfügungsverfahren nach dem vorhergehenden Anspruch, **dadurch gekennzeichnet, dass** die Verbindungsschicht (4) des ersten Substrats (1) und die Verbindungsschicht (5) des zweiten Substrats (2) aus dem gleichen Material sind.

6. Zusammenfügungsverfahren nach einem der Ansprüche 1 bis 3, **dadurch gekennzeichnet, dass** es außerdem vor dem Schritt des Inkontaktbringens und Verklebens einen Schritt des Bildens des Bereichs der Kontaktfläche des zweiten Substrats (2) mittels Abscheidung einer elektrisch leitenden Schicht (6) umfasst, die mindestens einen Teil einer Verbindungsschicht (5) bedeckt, die dazu geeignet ist, eine molekulare Adhäsion mit der Verbindungsschicht (4) des ersten Substrats (1) sicherzustellen, und dazu geeignet ist, sich im Laufe des Umwandlungsschritts mit der elektrisch leitenden Schicht (6) des zweiten Substrats (2) zu vereinen, um eine Leiterlegierung (11) zu bilden.

7. Zusammenfügungsverfahren nach dem vorhergehenden Anspruch, **dadurch gekennzeichnet, dass** die elektrisch leitende Schicht (6), die sich auf dem Bereich der Kontaktfläche des zweiten Substrats (2) befindet, gleichfalls dazu geeignet ist, sich im Laufe des Umwandlungsschritts mit dem Material der Verbindungsschicht (4), die sich auf dem ersten Substrat (1) befindet, zu vereinen, um eine Leiterlegierung (10) zu bilden, die in der bzw. den Legierungsbereichen enthalten ist.

8. Zusammenfügungsverfahren nach Anspruch 6 oder 7, **dadurch gekennzeichnet, dass** die Verbindungsschicht (4) des ersten Substrats (1) und die Verbindungsschicht (5) des zweiten Substrats (2) aus dem gleichen Material sind und dass die elektrisch leitende Schicht (3) des ersten Substrats (1) und die elektrisch leitende Schicht (6) des zweiten Substrats (2) aus dem gleichen Material sind.

9. Zusammenfügungsverfahren nach einem der vorhergehenden Ansprüche, **dadurch gekennzeichnet, dass** die elektrisch leitende Schicht (3, 6) des ersten Substrats (1) und/oder des zweiten Substrats (2) aus einem Stapel aus einem oder mehreren Schichten aus einem Metall oder aus Leiterlegierung ausgebildet werden.

10. Zusammenfügungsverfahren nach dem vorhergehenden Anspruch, **dadurch gekennzeichnet, dass** das Metall aus Nickel Ni, Platin Pt, Palladium Pd, Kobalt Co, Wolfram W, Tantal Ta, Titan Ti, Vanadium V, Chrom Cr, Mangan Mn, Eisen Fe, Molybdän Mo oder einem Gemisch dieser Elemente ausgewählt ist.

11. Zusammenfügungsverfahren nach Anspruch 9, **dadurch gekennzeichnet, dass** die Leiterlegierung aus Siliciden oder Germaniden von Nickel Ni, Platin Pt, Palladium Pd, Kobalt Co, Wolfram W, Tantal Ta, Titan Ti, Vanadium V, Chrom Cr, Mangan Mn, Eisen Fe oder Molybdän Mo ausgewählt ist.

12. Zusammenfügungsverfahren nach einem der Ansprüche 1 bis 9, **dadurch gekennzeichnet, dass** die Verbindungsschicht (4, 5) des ersten Substrats (1) und/oder des zweiten Substrats (2) aus einem Material ist, das aus Silicium, Germanium, Siliciumcarbid oder einem Gemisch dieser Elemente ausgewählt ist.

13. Zusammenfügungsverfahren nach einem der vorhergehenden Anspruche, **dadurch gekennzeichnet, dass** es außerdem vor dem Schritt des Abscheidens der Verbindungsschicht (4, 5) des ersten (1) und/oder des zweiten Substrats (2) einen Schritt des Behandelns der Oberfläche der elektrisch leitenden Schicht (3, 6) des ersten (1) und/oder des zweiten Substrats (2) umfasst, der mindestens einen Teil der auf seiner Oberfläche vorhandenen Oxide und/oder Isolatoren entfernen soll.

14. Zusammenfügungsverfahren nach einem der vorhergehenden Ansprüche, **dadurch gekennzeichnet, dass** es außerdem vor dem Schritt des Inkontaktbringens und Verklebens der Kontaktflächen der zwei Substrate einen Schritt des Oberflächenbehandelns der Oberfläche der Verbindungsschicht (4) des ersten Substrats (1) und des Bereichs der Kontaktfläche des zweiten Substrats (2) umfasst.

15. Zusammenfügungsverfahren nach dem vorhergehenden Anspruch, **dadurch gekennzeichnet, dass** der Oberflächenbehandfungsschritt in einer chemischen Vorbereitung besteht.

16. Zusammenfügungsverfahren nach einem der Ansprüche 14 oder 15, **dadurch gekennzeichnet, dass** der Oberflächenbehandlungsschritt in einer Behandlung besteht, die zu einer vollständig oder zum Teil hydrophoben Oberfläche führt.

17. Zusammenfügungsverfahren nach einem der Ansprüche 14 oder 15, **dadurch gekennzeichnet, dass** der Oberflächenbehandiungsschritt in einer Behandlung besteht, die zu einer vollständig oder zum Teil hydrophilen Oberfläche führt.

18. Zusammenfügungsverfahren nach Anspruch 14, **dadurch gekenntzeichnet, dass** der Oberflächenbehandlungsschritt in einer Plasmabehandlung mindestens einer der Kontaktflächen besteht, um eine hohe Klebkraft bei niedriger Temperatur zu erhalten.

19. Zusammenfügungsverfahren nach Anspruch 14, **dadurch gekennzeichnet, dass** der Oberflächenbehandlungsschritt in einer Behandlung mit UV-Licht und/oder einer Behandlung mit Ozon und/oder einer Wärmebehandlung und/oder einer Behandlung in einer Schutzgasatmosphäre besteht.
